**Europäisches Patentamt**

**European Patent Office**

**Office européen des brevets**

(19)

(11) Veröffentlichungsnummer: **0 137 159**

**B1**

(12) **EUROPÄISCHE PATENTSCHRIFT**

(45) Veröffentlichungstag der Patentschrift:
**12.10.88**

(21) Anmeldenummer: **84108650.7**

(22) Anmeldetag: **21.07.84**

(51) Int. Cl.⁴: **G 03 D 15/10**

(54) **Verfahren zur Herstellung von insbesondere Portraitphotos mittels Photomontage.**

(30) Priorität: **28.07.83 DE 3327163**

(43) Veröffentlichungstag der Anmeldung:
**17.04.85 Patentblatt 85/16**

(45) Bekanntmachung des Hinweises auf die Patenterteilung:
**12.10.88 Patentblatt 88/41**

(84) Benannte Vertragsstaaten:
**AT BE CH FR GB IT LI LU NL SE**

(56) Entgegenhaltungen:
**CH-A-63 186
DE-A-1 546 797
DE-C-189 062
DE-C-352 948
GB-A-840 738
US-A-3 728 190**

(73) Patentinhaber: **C.C. Creative Consulting S.A.,
Bruggwiesen 4, CH- 9302 Kronbühl (CH)**

(72) Erfinder: **Hendrikx Weidlich, Kristina,
Camphausenstrasse 10, D-4000 Düsseldorf (DE)**

(74) Vertreter: **Paul, Dieter- Alfred, Dipl.- Ing.,
Fichtestrasse 18, D-4040 Neuss 1 (DE)**

## Beschreibung

Die Erfindung betrifft ein Verfahren zur Herstellung von Photomontagen, insbesondere von Portraitphotos, bei dem ein erster Bildteil, z. B. eine Rumpfvorlage, mit einem zuvor maßstabsgerecht angepaßten und im Umriß ausgeschnittenen zweiten Bildteil, z. B. eine Kopfvorlage, kombiniert und diese Kombination photografiert wird.

Solche Photomontagen sind allgemein bekannt. Bei ihnen werden beispielsweise eine bestimmte Rumpfvorlage, also die Abbildung eines Körperrumpfes, mit beispielsweise einer Kopfvorlage, also der Abbildung eines bestimmten Kopfes, kombiniert und diese Kombination dann photografiert. Auf diese Weise können zur Erzielung bestimmter Effekte Photomontagen hergestellt werden, die die Kombination eines Kopfes mit einem nicht zugehörigen Rumpfkörper zeigen.

Eine derartige Photomontage ist sehr aufwendig und zeitraubend herzustellen. Die Anpassung der Kopfvorlage an die Rumpfvorlage muß außerordentlich genau sein, damit der angestrebte Effekt auch tatsächlich erreicht wird d. h. der Kopf nicht als Fremdkörper zu dem Rumpf erscheint. Noch schwieriger ist es, die Kombination aus Kopf- und Rumpfvorlage dann noch in einen bestimmten Hintergrund einzupassen, weshalb üblicherweise derartige Photomontagen ohne Hintergrund angefertigt werden.

Aus DE-C-189 062 ist es bekannt, eine ausgeschnittene auf abziehbarer Folie befindliche Personenaufnahme mit einer komplementär ausgeschnittenen, auf abziehbarer Folie befindlichen Hintergrundaufnahme auf einer Unterlage zu vereinigen.

Der Erfindung liegt deshalb die Aufgabe zugrunde, ein Verfahren der eingangs genannten Art derart weiterzuentwickeln, daß auf einfache und schnelle Weise eine Vielzahl verschiedener, jedoch hochwertiger Photomontagen hergestellt werden können.

Diese Aufgabe wird erfindungsgemäß dadurch gelöst, daß für die Herstellung der Kombination aus erstem und zweiten Bildteil, insbesondere aus Rumpf- und Kopfvorlage, der erste Bildteil photomechanisch auf eine Klarsichtfolie übertragen wird, daß die Klarsichtfolie auf ihrer Rückseite im Bereich des ersten Bildteils lichtdeckend abgedeckt wird, daß die Klarsichtfolie auf einen dritten Bildteil, z. B. ein Hintergrundmotiv gelegt und daß der zweite Bildteil zur Kombination mit dem ersten Bildteil zwischen Klarsichtfolie und dritten Bildteil gelegt wird. Zusätzlich können auf die Klarsichtfolie weitere Motive, beispielsweise Firmenzeichen, Werbetexte oder dergleichen, mit Siebdruck aufgetragen werden, und zwar vorzugsweise auf die Rückseite der Klarsichtfolie.

Erfindungsgemäß wird also für beispielsweise eine Rumpfvorlage und gegebenenfalls für Firmenzeichen, Werbetexte oder dergleichen ein Zwischenträger in Form der Klarsichtfolie angefertigt, der dann auf beispielsweise ein Hintergrundmotiv aufgelegt werden kann, wobei die Kopfvorlage zwischen beiden gelegt wird. Dabei braucht keine besondere Anpassung der Kopfvorlage an die Rumpfvorlage vorgenommen werden, da der untere Teil der Kopfvorlage durch die auf der Klarsichtfolie befindliche Rumpfvorlage so abgedeckt wird, daß ein perfekter Übergang erreicht wird.

Daneben bietet dieses Verfahren die Möglichkeit, auf einfache und schnelle Weise verschiedenste Kopfvorlagen zu montieren, indem einfach die Kopfvorlagen gegeneinander ausgetauscht werden. Ferner können verschiedene Rumpfvorlagen auf Klarsichtfolie und verschiedene Hintergrundmotive beliebig und auf sehr einfache und schnelle Weise miteinander kombiniert werden. Dabei zeichnen sich die erfindungsgemäßen Photomontagen durch eine Qualität aus, die nicht erkennen läßt, daß hier verschiedene Bestandteile miteinander montiert worden sind.

In der Zeichnung ist das erfindungsgemäße Verfahren durch Darstellung der einzelnen Verfahrensschritte an Hand einer beispielhaften Photomontage näher erläutert. Es zeigen:

Figur 1      eine Rumpfvorlage;
Figur 2      die Rumpfvorlage gemäß Figur 1, übertragen auf eine Klarsichtfolie zusammen mit einer Abdeckung und zwei Logos;
Figur 3      die fertiggestellte Klarsichtfolie gemäß Figur 2;
Figur 4      ein Hintergrundmotiv;
Figur 5      das Auflegen der Klarsichtfolie gemäß Figur 3 auf das Hintergrundmotiv gemäß Figur 4;
Figur 6      das Hintergrundmotiv gemäß Figur 4 mit aufgelegter Klarsichtfolie gemäß Figur 3;
Figur 7      Kopfvorlagen;
Figur 8      das Ausschneiden einer Kopfvorlage;
Figur 9      das Wegnehmen einer Kopfvorlage;
Figur 10     das Zwischenlegen einer Kopfvorlage zwischen Klarsichtfolie gemäß Figur 3 und Hintergrundmotiv gemäß Figur 4;
Figur 11     die fertige Photomontage und
Figur 12     das Auswechseln der Kopfvorlage.

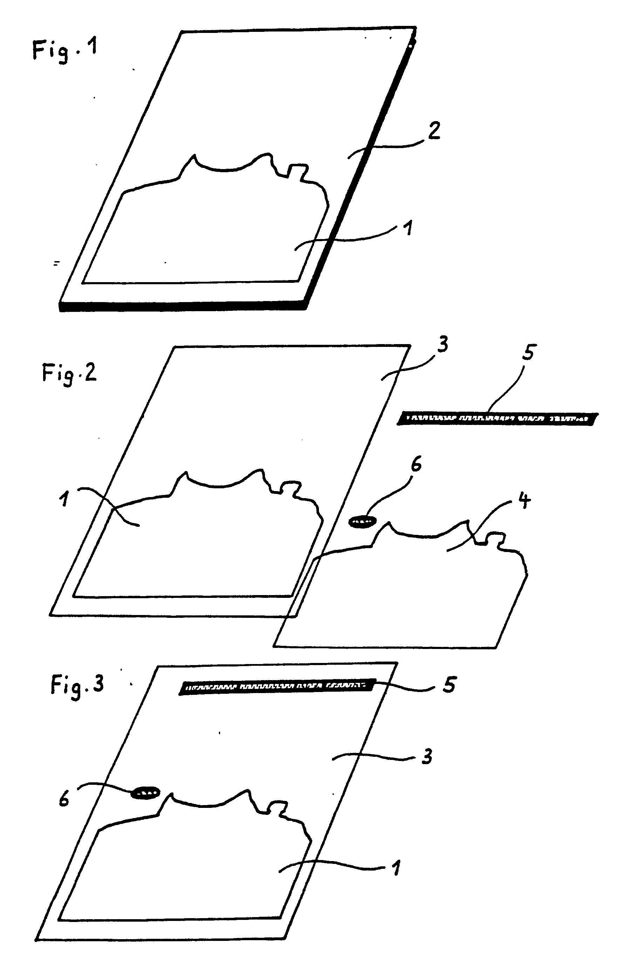

In Figur 1 ist eine Rumpfvorlage 1 auf eine Unterlage 2 aufgebracht. Durch ein üblicherweise bekanntes photomechanisches Verfahren wird diese Rumpfvorlage 1 auf die in Figur 2 dargestellte Klarsichtfolie 3 übertragen. Damit die Rumpfvorlage 1 auf der Klarsichtfolie 3 nicht lichtdurchlässig ist, wird sie rückseitig mit einer im Umriß der Rumpfvorlage 1 übereinstimmenden Abdeckung 4 versehen. Ferner können auf der Klarsichtfolie mittels Siebdruck die Logos 5 und 6 aufgebracht werden, zweckmäßigerweise auf deren Rückseite. Diese Logos können beispielsweise Firmenzeichen oder Werbetexte sein. Die auf diese Weise fertiggestellte Klarsichtfolie ist in Figur 3 zu sehen.

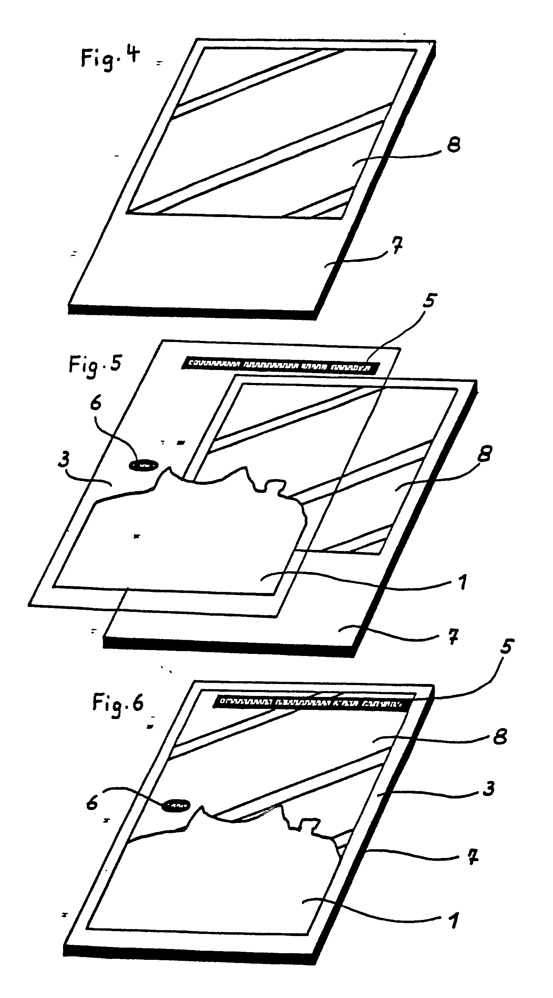

Figur 4 zeigt ein auf einer Unterlage 7 aufgezogenes Hintergrundmotiv 8. Figur 5 zeigt den Vorgang, wie die Klarsichtfolie 3 gemäß Figur 3 auf die Unterlage 7 und das Hintergrundmotiv 8 aufgelegt wird, so daß die Montage nach Figur 6 entsteht. Das Hintergrundmotiv 8 wird hier teilweise von der Rumpfvorlage 1 abgedeckt, ist jedoch ansonsten wegen der Durchsichtigkeit der Klarsichtfolie zu sehen, sieht man von den Logos 5, 6 ab.

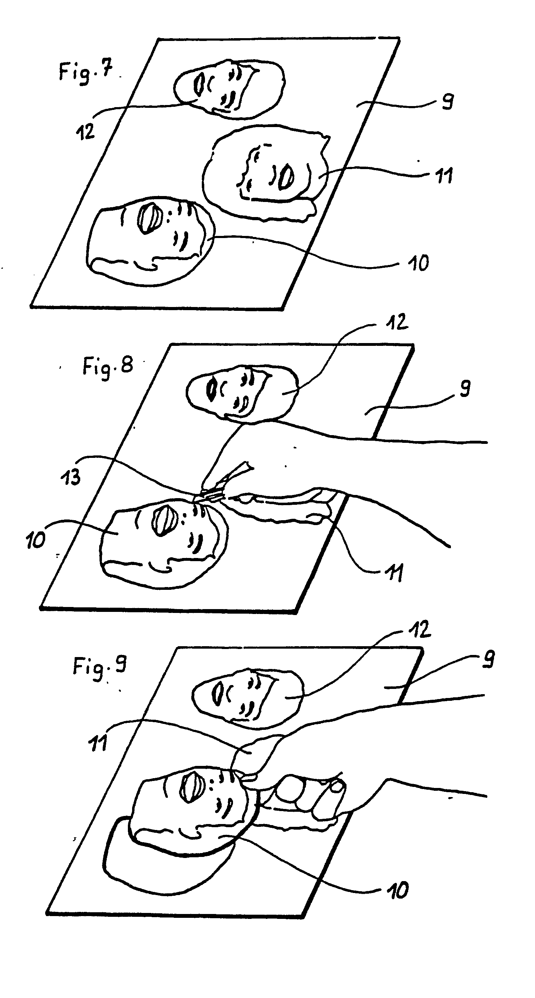

In Figur 7 sind auf einer Unterlage 9 aufgebrachte Kopfvorlagen 10, 11, 12 zu sehen, die von Photografien reproduziert und dabei an den Maßstab der Rumpfvorlage 1 angepaßt worden sind. Figur 8 zeigt, wie eine Kopfvorlage 10 von Hand mittels eines Messers 13 ausgeschnitten wird. In Figur 9 wird die Kopfvorlage 10 von der Unterlage 9 getrennt.

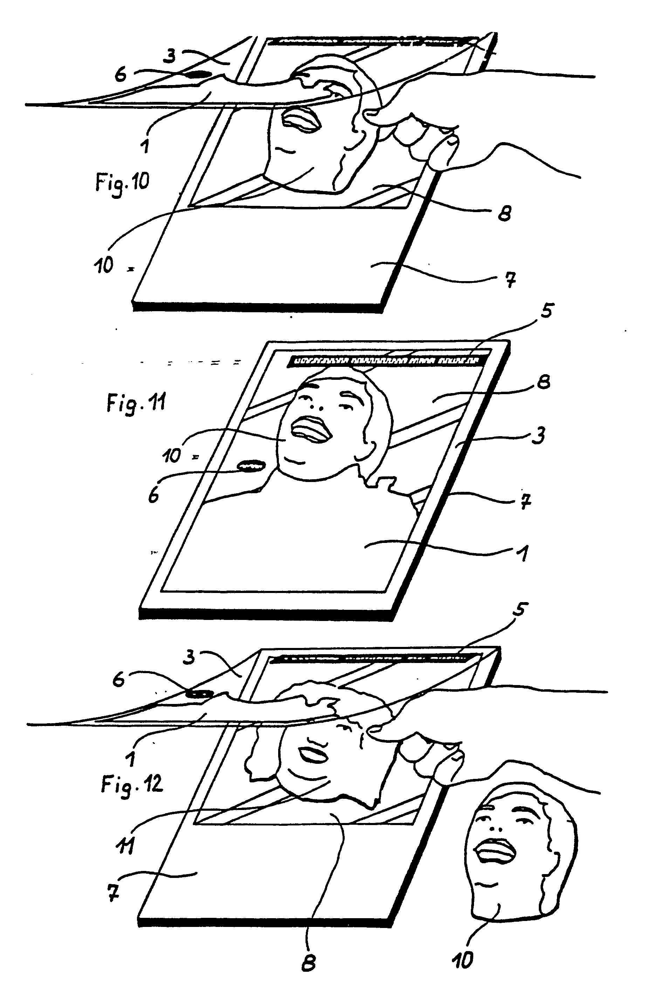

Die Kopfvorlage 10 wird anschließend nach Abheben der Klarsichtfolie 3 auf das Hintergrundmotiv 8 gelegte Figur 10, und zwar so, daß sie sich in der richtigen Lage im Bezug auf die Rumpfvorlage 1 befindet, wenn die Klarsichtfolie 3 wieder aufgelegt worden ist. Die fertige Montage zeigt Figur 11. Es ist zu sehen, daß der obere Rand der Rumpfvorlage 1 den unteren Teil der Halspartie der Kopfvorlage 10 abdeckt, so daß eine Anpassung in diesem Bereich nicht erforderlich ist. Dies läßt zu, die Kopfvorlage 10 frei an die Rumpfvorlage 1 anzupassen, bis ein möglichst natürlicher Eindruck entsteht.

Figur 12 zeigt den Austausch der Kopfvorlage 10 gegen die Kopfvorlage 11 aus Figur 7. Es ist lediglich erforderlich, die Kopfvorlage 10 herauszunehmen und an deren Stelle die Kopfvorlage 11 zu setzen. Dies geht sehr schnell und einfach vor sich. Es können also serienweise Photomontagen mit derselben Rumpfvorlage und demselben Hintergrundmotiv, aber verschiedenen Kopfvorlagen angefertigt werden.

Darüberhinaus besteht selbstverständlich auch die Möglichkeit, mehrere Klarsichtfolien mit verschiedenen Rumpfvorlagen anzufertigen, um sie gegen die hier dargestellte Klarsichtfolie 3 austauschen zu können. Eine weitere Variationsmöglichkeit besteht darin, mehrere Unterlagen mit verschiedenen Hintergrundmotiven anzufertigen, die dann mit den verschiedenen Klarsichtfolien und den unterschiedlichen Kopfvorlagen auf beliebige Heise miteinander kombiniert werden können. Das erfindungsgemäße Verfahren zeichnet sich somit durch hohe Flexibilität bei einfacher Handhabung aus.

Natürlich ist das erfindungsgemäße Verfahren nicht auf die Photomontage von Portraitphotos beschränkt. Es läßt sich überall dort anwenden, wo zwei Bildteile vor einem dritten Bildteil miteinander kombiniert werden sollen.

**Patentansprüche**

1. Verfahren zur Herstellung von Photomontagen, insbesondere von Portraitphotos, bei dem ein erster Bildteil, z. B. eine Rumpfvorlage, mit einem zuvor maßstabsgerecht angepaßten und im Umriß ausgeschnittenen zweiten Bildteil, z. B. eine Kopfvorlage, kombiniert und diese Kombination photografiert wird, dadurch gekennzeichnet, daß zur Herstellung der Kombination der erste Bildteil (1) photomechanisch auf eine Klarsichtfolie (3) übertragen wird, daß die Klarsichtfolie (3) auf ihrer Rückseite im Bereich des ersten Bildteils (1) lichtdeckend abgedeckt wird, daß die Klarsichtfolie (3) auf einen dritten Bildteil, z. B. ein Hintergrundmotiv (8) gelegt und daß der zweite Bildteil (10, 11, 12) zur Kombination mit dem ersten Bildteil (1) zwischen Klarsichtfolie (3) und dritten Bildteil (8) gelegt wird.

2. Verfahren nach Anspruch 1, dadurch gekennzeichnet, daß auf die Klarsichtfolie (3) weitere Motive, beispielsweise Firmenzeichen, Werbetexte oder dergleichen (5, 6) mit Siebdruck aufgetragen werden.

**Claims**

1. Method for producing photo-montages, especially portrait photos, wherein a first picture part, e.g. a body master, is combined with a second picture part, e.g. a head master, which has previously been matched in the correct scale and cut out round its outline, and this combination is photographed, characterised in that, to produce the combination, the first picture part (1) is transferred photo-mechanically to a transparent sheet (3), that the transparent sheet (3) is covered at its rear face in the region of the first picture part (1) in a light-masking manner, that the transparent sheet (3) is laid on to a third picture part e.g. a background motif (8), and that the second picture part (10, 11, 12) is laid between the transparent sheet (3) and the third picture part (8) for combination with the first picture part (1).

2. Method according to claim 1, characterised in that further motifs, for example firms' signs or logos, advertising texts or the like (5, 6), are applied with screen printing on to the transparent sheet (3).

**Revendications**

1. Procédé de fabrication par photomontages, notamment de photoportraits, qui consiste à combiner une première partie d'image, par exemple un original de tronc à une deuxième partie d'image, par exemple à un original de tête, qui a été préalablement mise à l'échelle et découpée sur le contour, et à photographier cette combinaison,

caractérisé en ce qu'il consiste, pour fabriquer la combinaison, à reporter la première partie d'image (1) photomécaniquement sur une feuille transparente (3), à recouvrir de manière opaque le verso de la feuille transparente (3) dans la région de la première partie d'image (1), à mettre la feuille transparente (3) sur une troisième partie d'image, par exemple sur un motif d'arrière-plan (8), et à mettre la deuxième partie d'image (10, 11, 12) pour la combiner à la première partie d'image (1), entre la feuille transparente (3) et la troisième partie d'image (8).

2. Procédé suivant la revendication 1, caractérisé en ce qu'il consiste à apposer par sérigraphie sur la feuille transparente (3) d'autres motifs, par exemple des signes de société, des textes publicitaires ou analogues (5, 6).

Fig. 1

Fig. 2

Fig. 3

Fig. 4

Fig. 5

Fig. 6

Fig. 7

12

9

11

10

Fig. 8

12

9

13

10

11

Fig. 9

12

9

11

10

Fig. 10

Fig. 11

Fig. 12